(19) Europäisches Patentamt
European Patent Office
Office européen des brevets

(11) **EP 3 489 698 A1**

(12) **EUROPEAN PATENT APPLICATION**
published in accordance with Art. 153(4) EPC

(43) Date of publication:
**29.05.2019 Bulletin 2019/22**

(51) Int Cl.:
*G01R 31/02* (2006.01)　　*G01R 31/36* (2019.01)
*H01M 10/48* (2006.01)　　*H02H 3/00* (2006.01)
*H02J 7/00* (2006.01)

(21) Application number: **17830818.5**

(22) Date of filing: **30.06.2017**

(86) International application number:
**PCT/JP2017/024227**

(87) International publication number:
**WO 2018/016298 (25.01.2018 Gazette 2018/04)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **20.07.2016 JP 2016142419**

(71) Applicants:
• **Kabushiki Kaisha Toshiba
Minato-ku
Tokyo 105-8001 (JP)**
• **Toshiba Infrastructure Systems &
Solutions Corporation
Kawasaki-shi, Kanagawa 212-0013 (JP)**

(72) Inventors:
• **MURAKAMI, Manabu
Tokyo 105-8001 (JP)**
• **OOSAWA, Takeshi
Tokyo 105-8001 (JP)**
• **YAMAUCHI, Nobuyuki
Tokyo 105-8001 (JP)**
• **OBATA, Yoshimori
Fuchu-shi
Tokyo 183-8511 (JP)**

(74) Representative: **Hoffmann Eitle
Patent- und Rechtsanwälte PartmbB
Arabellastraße 30
81925 München (DE)**

(54) **EARTH LEAKAGE DETECTING DEVICE AND EARTH LEAKAGE DETECTING METHOD**

(57) An electric leakage detection method according to embodiments provides an electric leakage detection apparatus and method to accurately detect electric leakage and comprises measuring a set of a first voltage, which is the voltage at both ends of the second resistor, and the total voltage a plurality of times to be recorded in the memory by the control apparatus in a state where one of the first switch SW1 and the second switch SW2 is closed and an other of the first switch SW1 and the second switch SW2 is opened; measuring, by the voltage detector VS, at least one second voltage VLS, which is the voltage at both ends of the second resistor R2 and corresponds to the total voltage Vb2 whose difference from any one of a plurality of the total voltages Vb1 recorded in the memory is equal to or less than a voltage threshold value, computing a total insulation resistance RL between the storage battery group 10 and the ground by using the total voltage Vb, the first voltage VL1, and the second voltage VL2; and determining presence of electric leakage when a value of the total insulation resistance RL is equal to or less than an electric leakage threshold value.

FIG. 4

**Description**

FIELD

Embodiments of the present invention relate to an electric leakage detection apparatus and an electric leakage detection method.

BACKGROUND

For example, in a vehicle such as an electric automobile, a hybrid car or the like, a storage battery group (battery pack) is mounted as a driving power supply. If conduction occurs between a human body and the high-voltage storage battery group for the vehicle, an electric current flows from the high-voltage storage battery group to the human body, and the human body gets an electric shock. Thus, the high-voltage storage battery group and a chassis ground of the vehicle are electrically separated to ensure the safety of the human body.

However, a situation where the insulation of the high-voltage storage battery group cannot be maintained due to vehicle trouble or the like is presumed. Therefore, in order to ensure the safety of the human body more reliably, it is desirable to be able to detect electric leakage between the high-voltage storage battery group and the chassis ground.

CITATION LIST

PATENT LITERATURE

Patent Literature 1: Japanese Patent No. 2838462

SUMMARY

In a state where the storage battery group is neither charging nor discharging, there is no fluctuation of the battery voltage so that it is possible to accurately measure the insulation resistance. However, since the battery voltage fluctuates during a period when the storage battery group is charging or discharging, there has been a possibility that an error may occur when the insulation resistance is measured.

Embodiments of the present invention have been made in light of the above circumstances, and an object thereof is to provide an electric leakage detection apparatus and an electric leakage detection method, which accurately detect electric leakage.

An electric leakage detection method of an electric leakage detection apparatus according to an embodiment comprising a first terminal electrically connected to a main circuit positive electrode terminal of a storage battery group; a second terminal electrically connected to a main circuit negative electrode terminal of the storage battery group; a first switch that switches electrical connection between the first terminal and a ground; a second switch that switches electrical connection between the second terminal and the ground; a first positive electrode side resistor and a second resistor connected in series between the first switch and the ground; a first negative electrode side resistor connected in series to the second resistor between the second switch and the ground; a voltage detector that detects a voltage at both ends of the second resistor; and a control apparatus that comprises a memory and records, in the memory, a value of the voltage detected by the voltage detector and a total voltage between the first terminal and the second terminal, the total voltage being computed based on a voltage transmitted from a monitoring apparatus that monitors a cell voltage of the storage battery group, the electric leakage detection method comprises measuring a set of a first voltage, which is the voltage at both ends of the second resistor, and the total voltage a plurality of times to be recorded in the memory by the control apparatus in a state where one of the first switch and the second switch is closed and an other of the first switch and the second switch is opened; measuring, by the voltage detector, at least one second voltage, which is the voltage at both ends of the second resistor and corresponds to the total voltage whose difference from any one of a plurality of the total voltages recorded in the memory is equal to or less than a voltage threshold value, in a state where one of the first switch and the second switch is opened and an other of the first switch and the second switch is closed; computing a total insulation resistance between the storage battery group and the ground by using the total voltage, the first voltage, and the second voltage; and determining presence of electric leakage when a value of the total insulation resistance is equal to or less than an electric leakage threshold value.

BRIEF DESCRIPTION OF THE DRAWING(S)

FIG. 1 is a diagram schematically showing a configuration example of a battery pack in which an electric leakage detection apparatus according to a first embodiment is mounted.

FIG. 2 is a circuit diagram for explaining one example of the configuration and operation of the insulation resistance drop detector.

FIG. 3 is a circuit diagram for explaining one example of the configuration and operation of the insulation resistance drop detector.

FIG. 4 is a circuit diagram for explaining one example of the configuration and operation of an insulation resistance drop detector of an electric leakage detection apparatus according to a second embodiment.

FIG. 5 is a diagram showing one example of time changes of the total voltage and measured values in time series.

FIG. 6 is a diagram showing one example of the voltages at both ends of the second resistor when the first switch and the second switch are switched.

FIG. 7 is a diagram showing one example of the voltages at both ends of the second resistor when the first switch and the second switch are switched.

FIG. 8 is a diagram showing one example of the total voltage of the battery pack controlled in a predetermined range in time series.

DETAILED DESCRIPTION

An electric leakage detection apparatus and an electric leakage detection method according to a first embodiment will be described below with reference to the drawings.

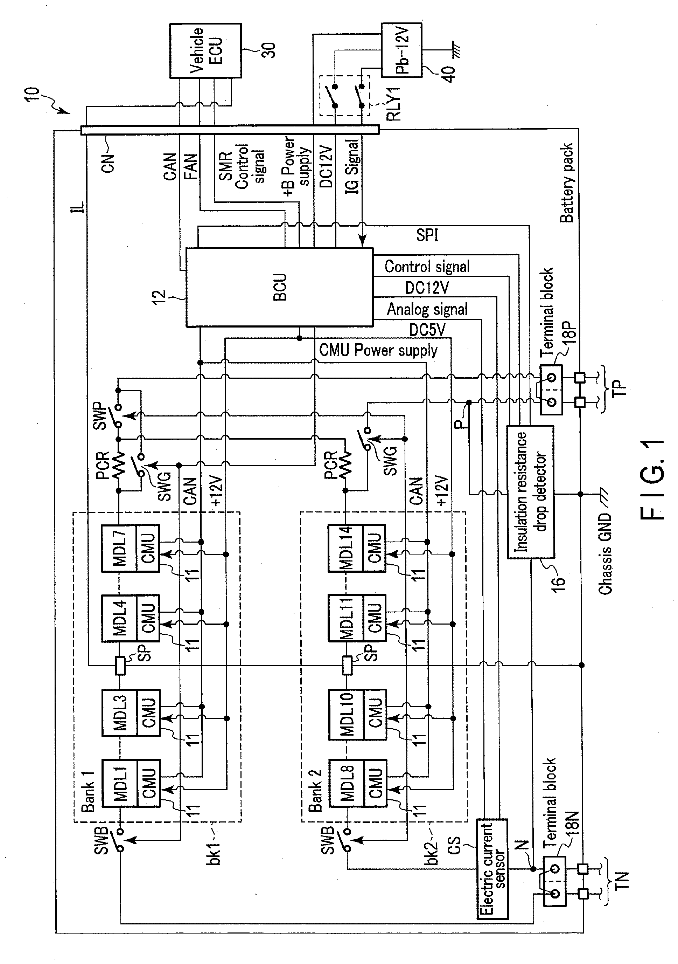

FIG. 1 is a diagram schematically showing a configuration example of a battery pack in which the electric leakage detection apparatus according to the first embodiment is mounted.

A battery pack (storage battery group) 10 to which the electric leakage detection apparatus according to this embodiment is applied is mounted as a storage battery group, for example, in a hybrid car. The hybrid car includes the battery pack 10, a vehicle ECU 30, and a 12 V lead battery 40. The battery pack 10 includes a first battery bank bkl, a second battery bank bk2, a battery control apparatus (i.e., battery control unit, BCU) 12, an insulation resistance drop detector 16, terminal blocks 18P and 18N, an electric current sensor CS, precharge resistors PCR, a precharge switch SWP, main circuit switches SWG and SWB, a connector CN, a main circuit positive electrode terminal TP and a main circuit negative electrode terminal TN. The battery pack 10 is grounded to a chassis ground. The electric leakage detection apparatus according to this embodiment includes the insulation resistance drop detector 16 and the battery control apparatus 12 serving as a control apparatus.

The first battery bank bk1 and the second battery bank bk2 are connected in parallel to each other. The first battery bank bk1 and the second battery bank bk2 have the same configuration.

The first battery bank bk1 includes a plurality of battery modules MDL1 to MDL7 connected in series, and a plurality of battery monitoring circuits (i.e., cell monitoring units, CMU) 11 which monitor the voltages and temperatures of the plurality of respective battery modules MDL1 to MDL7.

Note that the battery module MDL3 and the battery module MDL4 are connected via a service plug SP. The operation of the service plug SP is monitored by an interlock (IL) signal from the vehicle ECU 30 which is a host control apparatus.

Each of the battery modules MDL1 to MDL7 includes a plurality of battery cells (not shown).

The second battery bank bk2 includes a plurality of battery modules MDL8 to MDL14 connected in series, and a plurality of battery monitoring circuits 11 which monitor the voltages and temperatures of the plurality of respective battery modules MDL8 to MDL14.

Note that the battery module MDL10 and the battery module MDL11 are connected via a service plug SP. The operation of the service plug SP is monitored by an interlock (IL) signal from the vehicle ECU 30 which is a host control apparatus.

Each of the battery modules MDL8 to MDL14 includes a plurality of battery cells (not shown).

The battery monitoring circuits 11 detect the voltages of the battery cells included in the plurality of respective battery modules MDL1 to MDL14 and transmit the values to the battery control apparatus 12 based on a control area network (CAN) communication protocol. The battery monitoring circuits 11 also detect the temperatures of the plurality of respective battery modules MDL1 to MDL14 and transmits the values to the battery control apparatus 12 based on the CAN communication protocol.

A positive electrode terminal of the first battery bank bk1 and a positive electrode terminal of the second battery bank bk2 are electrically connected at the terminal block 18P on the positive electrode side via the main circuit switches SWG. The terminal block 18P on the positive electrode side is electrically connected to the main circuit positive electrode terminal TP. A negative electrode terminal of the first battery bank bk1 and a negative electrode terminal of the second battery bank bk2 are electrically connected at the terminal block 18N on the negative electrode side via the changeover switches SWB. The terminal block 18N on the negative electrode side is electrically connected to the main circuit negative electrode terminal TN.

The precharge switch SWP is a switching element which switches the connection between the positive terminals of the first battery bank bk1 and the second battery bank bk2 and the terminal block 18P on the positive electrode side. The precharge resistors PCR are interposed between the precharge switch SWP and the positive electrode terminal of the first battery bank bk1 and between the precharge switch SWP and the positive electrode terminal of the second battery bank bk2.

The operation of the precharge switch SWP is controlled by the battery control apparatus 12. When the precharge switch SWP is closed, the positive electrode terminal of the first battery bank bk1 and the positive electrode terminal of the second battery bank bk2 are electrically connected to the terminal block 18P on the positive electrode side via the precharge resistors PCR, and a large electric current is prevented from flowing between the first battery bank bk1 and the second battery bank bk2 and between the terminal blocks 18P and 18N and the vehicle system.

Moreover, the precharge resistors PCR and the precharge switch SWP are connected in parallel to the main circuit switches SWG. That is, the main circuit switches SWG are switching elements which switch the connection between terminal block 18P on the positive electrode side and each of the positive electrode terminal of the first battery bank bk1 and the positive electrode terminal of the second battery bank bk2. The operations of the main circuit switches SWG are controlled by the battery control apparatus 12.

The electric current sensor CS is arranged before the terminal block 18N on the negative electrode side and detects the charging electric current and the discharging electric current of the battery pack 10. The value of the electric current detected by the electric current sensor CS is transmitted to the battery control apparatus 12.

The battery control apparatus 12 is configured to be connectable to the vehicle ECU 30 and the lead battery 40 via the connector CN. For example, when the ignition of the vehicle is turned on, a vehicle side relay RLY1 is turned on, and DC 12V is supplied from the lead battery 40 to the battery control apparatus 12. The battery control apparatus 12 transforms DC 12V supplied from the lead battery 40 as necessary and supplies DC 12V or DC 5V to the battery monitoring circuits 11, the battery control apparatus 12, the insulation resistance drop detector 16 and the electric current sensor CS.

Furthermore, +B power supply is supplied from the lead battery 40 to the battery control apparatus 12. The +B power supply is always fed for backup, but no electric current flows unless the ignition signal turns on.

The battery control apparatus 12 can switch the main circuit switches SWG and SWB and the precharge switch SWP based on a control signal and the value of the electric current transmitted from the electric current sensor CS.

Further, the battery control apparatus 12 is configured to be capable of communicating the control signal to the insulation resistance drop detector 16. This control signal is a signal which stops the power supply from the battery control apparatus 12, for example, when electric leakage of the battery pack 10 is detected by the insulation resistance drop detector 16.

The battery control apparatus 12 is configured to be capable of communicating with the vehicle ECU 30, which is a host control apparatus, based on a controller area network (CAN) protocol. In addition, the battery control apparatus 12 controls on/off operations of the precharge switch SWP and the main circuit switches SWG and SWB based on a main circuit switch control signal supplied from the vehicle ECU 30.

The battery control apparatus 12 is a control apparatus including at least one processor such as, for example, a central processing unit (CPU), a micro processing unit (MPU) or the like, and at least one memory. The battery control apparatus 12 communicates with the vehicle ECU 30 and the battery monitoring circuits 11 based on the CAN protocol. The battery control apparatus 12 communicates with the insulation resistance drop detector 16 by, for example, a serial peripheral interface (SPI) communication mode.

The battery control apparatus 12 receives the voltages of the battery cells and the temperatures of the battery modules from the battery monitoring circuits 11 and estimates a state of charge (SOC) and the like. Moreover, the battery control apparatus 12 controls the operations of the battery monitoring circuits 11, the insulation resistance drop detector 16 and the electric current sensor CS.

The insulation resistance drop detector 16 detects insulation resistance values between a total positive electrode terminal P and a total negative electrode terminal N of the first battery bank bk1 and the second battery bank bk2 and the chassis ground and detects whether or not there is electric leakage from the battery pack 10. The total positive electrode terminal P is electrically connected to the main circuit positive electrode terminal TP of the battery pack 10. The total negative electrode terminal N is electrically connected to the main circuit negative electrode terminal TN of the battery pack 10.

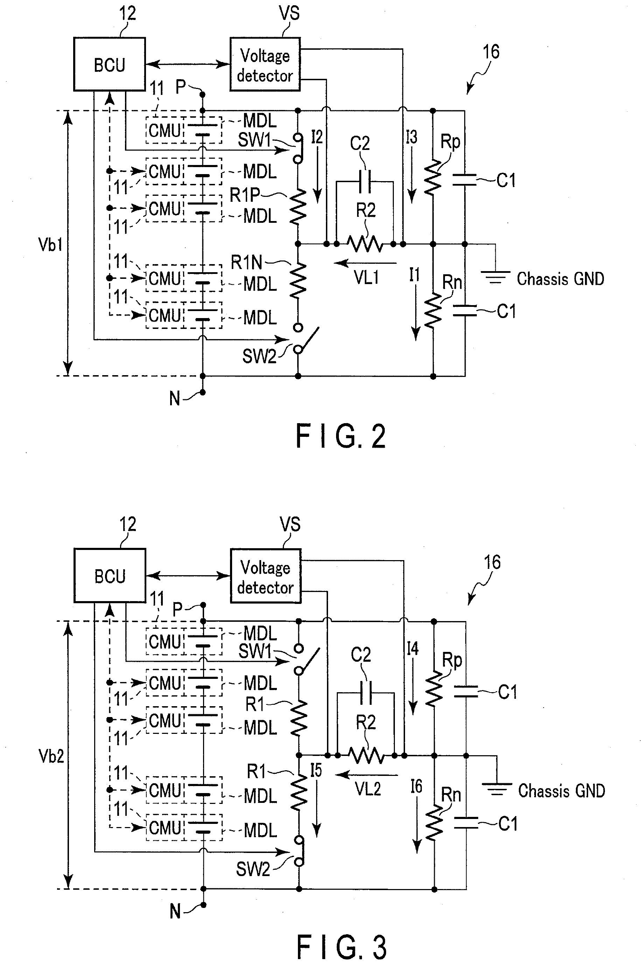

FIGS. 2 and 3 are circuit diagrams for explaining one example of the configuration and operation of the insulation resistance drop detector.

The insulation resistance drop detector 16 includes a first switch SW1, a second switch SW2, a first positive electrode side resistor RIP, a first negative electrode side resistor R1N, a second resistor R2 and a voltage detector VS. Note that a resistance Rp is an insulation resistance generated between the total positive electrode terminal (first terminal) P and the chassis ground, and a resistance Rn is an insulation resistance generated between the total negative electrode terminal (second terminal) N and the chassis ground. These resistances are virtually described as resistors.

The first switch SW1 is a switching element which switches the electrical connection between the total positive electrode terminal P and the chassis ground. The first switch SW1 is a switching element capable of controlling the electrical operation, and the operation thereof is controlled by the battery control apparatus 12.

The second switch SW2 is a switching element which switches the electrical connection between the total negative electrode terminal N and the chassis ground. The second switch SW2 is a switching element capable of controlling the electrical operation, and the operation thereof is controlled by the battery control apparatus 12.

The first positive electrode side resistor R1P and the second resistor R2 are connected in series between the first switch SW1 and the chassis ground. The first negative electrode side resistor R1N and the second resistor R2 are connected in series between the second switch SW2 and the chassis ground. The first positive electrode side resistor R1P and the first negative electrode side resistor R1N have the same size (= R1).

The voltage detector VS detects voltages VL1 and VL2 at both ends of the second resistor R2 at a predetermined timing and transmits the detected values to the battery control apparatus 12. The operation of the voltage detector VS is controlled by the battery control apparatus 12.

Next, with reference to FIGS. 2, 3, and 5, the electric leakage detection method using the insulation resistance drop detector 16 will be described.

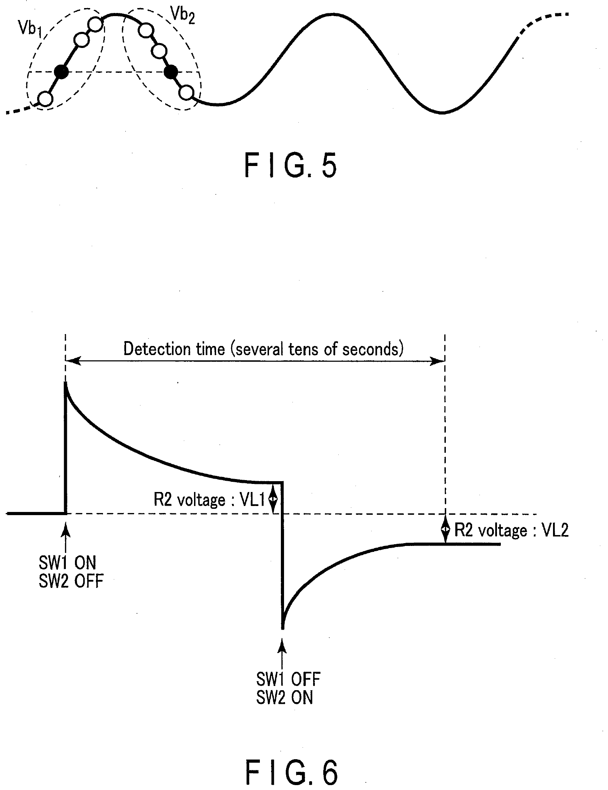

FIG. 5 is a diagram showing one example of time changes of the total voltage and measured values in time series.

The battery control apparatus 12 closes the first switch SW1 and brings the second switch SW2 into an opened state. At this time, the electric current flowing through the insulation resistance Rn is I1, the electric current flowing through the insulation resistance Rp is I3, the electric current flowing through the first positive electrode side resistor R1P is I2, the voltage (total voltage) between the total positive electrode terminal P and the total negative electrode terminal N is Vb1, and the voltage (first voltage) at both ends of the second resistor R2 is VL1. Note that the following relationship is established at this time.

$$Vb1 = I1 \times Rn + (R1 + R2) \times I2$$

$$Rp \times I3 = (R1 + R2) \times I2$$

$$VL1 = R2 \times I2$$

From the above relationship and I1 = I2 + I3, the relationship of the following expression (1) is established.
[Expression 1]

$$\frac{Vb1}{VL1} = \left( \frac{1}{R2} + \frac{R1+R2}{R2 \times Rp} \right) \times Rn + \frac{(R1+R2)}{R2} \cdots (1)$$

Subsequently, the battery control apparatus 12 controls the voltage detector VS to measure the voltage VL1 at both ends of the second resistor R2. Moreover, based on the battery cell voltages of the battery modules MDL1 to MDL14 received from the battery monitoring circuits 11, the battery control apparatus 12 measures the total voltage Vb1 when the voltage VL1 is measured, and associates the voltage VL1 and the total voltage Vb1 to be recorded in the memory.

Note that, in this embodiment, the battery control apparatus 12 measures a set of the voltage VL1 and the total voltage Vb1 a plurality of times to be recorded in the memory in a period when the first switch SW1 is closed. The battery control apparatus 12 may control the first switch SW1 to continuously close in a predetermined period for measuring the set of the voltage VL1 and the total voltage Vb1 a plurality of times or may control the first switch SW1 to intermittently close in synchronization with the timing at which the voltages VL1 and Vb1 are measured.

Furthermore, the battery control apparatus 12 measures the set of the voltage VL1 and the total voltage Vb1 a plurality of times to be recorded in the memory prior to a command to detect electric leakage from the vehicle ECU 30. The battery control apparatus 12 may control to periodically update the values of the voltages VL1 and Vb1 stored in the memory. At this time, when the same value as the measured total voltage Vb1 is already recorded in the memory, the battery control apparatus 12 updates the values recorded in the memory by the values of the newly measured voltages VL1 and Vb1.

Subsequently, when the electric leakage detection command is received from the vehicle ECU 30, the battery control apparatus 12 opens the first switch SW1 and brings the second switch SW2 into a closed state. At this time, the electric current flowing through the insulation resistance Rp is I4, the electric current flowing through the first negative electrode side resistor R1N is I5, the electric current flowing through the insulation resistance Rn is I6, the total voltage is Vb2, and the voltage (second voltage) at both ends of the second resistor R2 is VL2. Then, the following relationship is established.

$$Vb2 = I4 \times Rp + (R1 + R2) \times I5$$

$$Rn \times I6 = (R1 + R2) \times I5$$

$$VL2 = R2 \times I5$$

From the above relationship and I4 = I5 + I6, the relationship of the following expression (2) is established.
[Expression 2]

$$\frac{Vb2}{VL2} = \left( -\frac{1}{R2} - \frac{R1+R2}{R2 \times Rn} \right) \times Rp - \frac{(R1+R2)}{R2} \cdots (2)$$

Subsequently, the battery control apparatus 12 controls the voltage detector VS to measure the voltage VL2 at both ends of the second resistor R2. Further, based on the battery cell voltages of the battery modules MDL1 to MDL14 received from the battery monitoring circuits 11, the battery control apparatus 12 measures the total voltage Vb2 when the voltage VL2 is measured, and associates the voltage VL2 and the total voltage Vb2 to be recorded in the memory.
Note that the battery control apparatus 12 should only compare the measured total voltage Vb2 with the values of the plurality of total voltages Vb1 recorded in the memory and record, in the memory, the total voltage Vb2 with the same value (or a close value) as any one of the plurality of total voltages Vb1 and the voltage VL2 measured at the same time as this total voltage Vb2. Therefore, at least one set of the voltage VL2 and the total voltage Vb2 may be recorded in the memory.
Subsequently, as shown in FIG. 5, the battery control apparatus 12 calculates a value of a total insulation resistance RL by using the values of the voltages VL1 and VL2 and the total voltages Vb1 and Vb2 (the values indicated by the black circles in FIG. 5) when the total voltage Vb1 and the total voltage Vb2 are equal. When the total voltage Vb1 and the total voltage Vb2 are equal, the total insulation resistance RL can be computed by the following expression.
[Expression 3]

$$RL = \frac{R2 \times Vb}{VL1 - VL2} - (R1 + R2) \quad \cdots (3)$$

Note that, to compute the total insulation resistance RL by the above expression (3), the values of the total voltage Vb1 and the total voltage Vb2 need not be equal and may be different values as long as the error of the total insulation resistance RL has a difference that falls within a predetermined range. That is, if the difference between the total voltage Vb1 and the total voltage Vb2 is equal to or less than the allowable voltage threshold value, the value of the total insulation resistance RL calculated by the aforementioned expression (1) can be employed.
As described above, by computing the total insulation resistance RL by the expression (3) using the values of the voltages VL1 and VL2 and the total voltages Vb1 and Vb2 at the timing when the total voltage Vb1 and the total voltage Vb2 are equal, it is possible to accurately compute the value of the total insulation resistance RL even when the battery pack 10 is charging or discharging.
The battery control apparatus 12 compares the value of the insulation resistance RL calculated as described above with a predetermined electric leakage threshold value (e.g., 100 kΩ or less) and determines the presence of electric leakage when the insulation resistance RL is equal to or less than the predetermined electric leakage threshold value. When the presence of the electric leakage is determined, the battery control apparatus 12, for example, notifies the vehicle ECU 30 of the trouble. In response to the receipt of the notification of the trouble from the battery control apparatus 12, the vehicle ECU 30, for example, transmits a command to stop the operation (charging, discharging or the like) to the battery control apparatus 12 and stops the battery pack 10.

According to this embodiment, the battery control apparatus 12 can accurately compute the value of the total insulation resistance RL, and it is possible to provide the electric leakage detection apparatus and the electric leakage detection method, which accurately detect electric leakage.

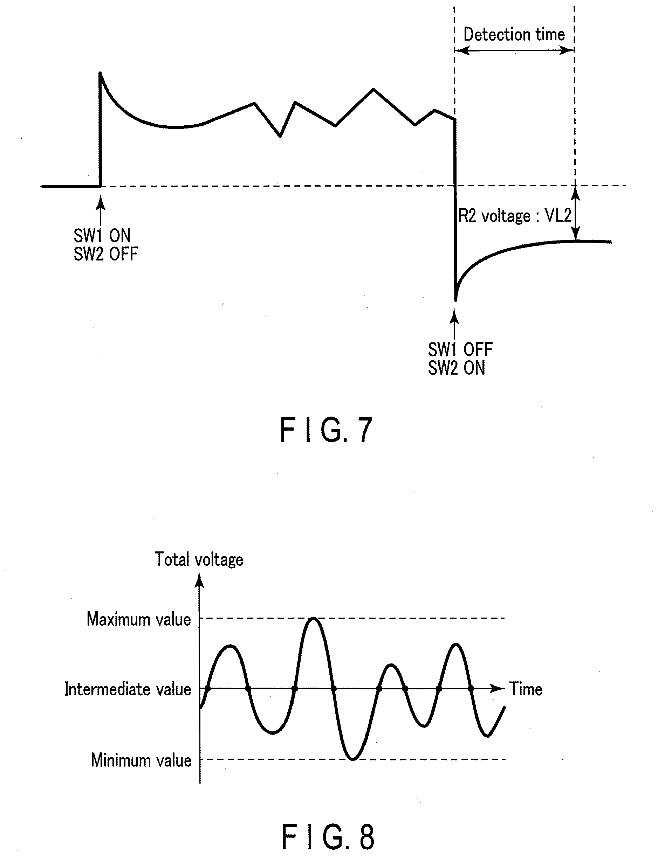

FIGS. 6 and 7 are diagrams showing one example of the voltages at both ends of the second resistor when the first switch and the second switch are switched.

Moreover, as shown in FIG. 6, when the first switch SW1 and the second switch SW2 are switched, a time constant is generated due to a capacitance C1 between the total positive electrode terminal P and the chassis, a capacitance C1 between the total negative electrode terminal N and the chassis, a noise elimination capacitor C2 connected in parallel to the second resistor R2, and the second resistor R2. Thus, the second resistor R2 has a large resistance value so that, for example, several tens of seconds are required for the values of the voltages VL1 and VL2 to be stable after the first switch SW1 and the second switch SW2 are switched. In this embodiment, as shown in FIG. 7, prior to the command to detect electric leakage from the vehicle ECU 30, a set of the voltage VL1 and the total voltage Vb1 is measured a plurality of times, and the previous value is updated as a new value for the same Vb1. Thus, the time require for the electric leakage detection is affected by only a time constant of a state where the second switch SW2 is closed and the first switch SW1 is opened, and the time required to end the electric leakage detection after the command is received from the vehicle ECU 30 can be shortened to be approximately halved.

Note that the voltage VL2 and the total voltage Vb2 are measured after the set of the voltage VL1 and the total voltage Vb1 is measured a plurality of times and recorded in the memory in the above embodiment, but the voltage VL1 and the total voltage Vb1 may be measured after the set of the voltage VL2 and the total voltage Vb2 is measured a plurality of times and recorded in the memory. Even in that case, the total voltage Vb2 is measured after the voltage VL2 is measured, then the set of the measured voltages VL2 and Vb2 is recorded in the memory a plurality of times. Thereafter, the voltage VL1 and the total voltage Vb1 are measured, and the total insulation resistance RL is computed by using the voltages VL1 and VL2 and the total voltages Vb1 and Vb2 when the total voltage Vb2 and the total voltage Vb1 are equal. It is thereby possible to obtain the same effects as the above embodiment.

Next, an electric leakage detection apparatus and an electric leakage detection method according to a second embodiment will be described below with reference to the drawings. Note that, in the following description, components the same as those in the above first embodiment are denoted by the same reference signs, and the descriptions thereof will be omitted.

As in the first embodiment, a battery pack 10 to which the electric leakage detection apparatus according to this embodiment is applied is mounted, for example, in a hybrid car. The configurations of a battery control apparatus 12 and an insulation resistance drop detector 16 of the electric leakage detection apparatus according to this embodiment are different from those in the first embodiment.

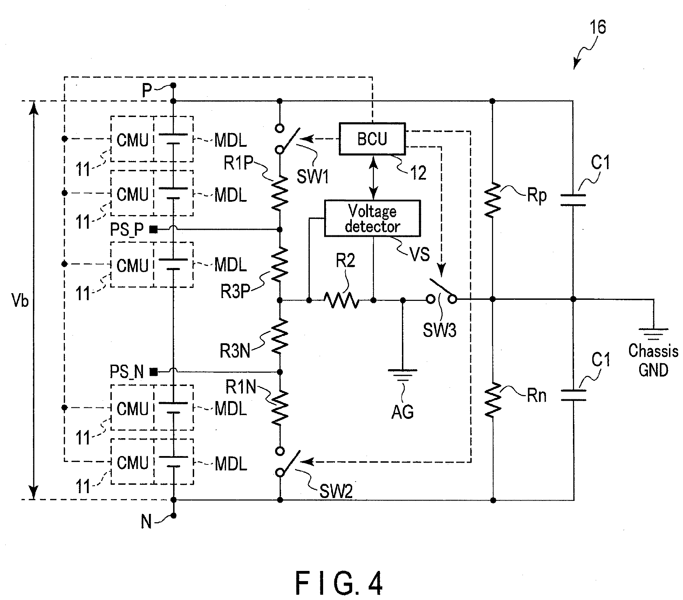

FIG. 4 is a circuit diagram for explaining one example of the configuration and operation of the insulation resistance drop detector of the electric leakage detection apparatus according to the second embodiment.

The insulation resistance drop detector 16 further includes a third positive electrode side resistor R3P, a third negative electrode side resistor R3N, a third switch SW3 and a reference voltage AG.

The third positive electrode side resistor R3P on the positive electrode side is connected in series between a first positive electrode side resistor R1P and a second resistor R2. The third negative electrode side resistor R3N on the negative electrode side is connected in series between a first negative electrode side resistor R1N and the second resistor R2. The third positive electrode side resistor R3P and the third negative electrode side resistor R3N have the same size (= R3).

The third switch SW3 is a switching element which switches the connection between the second resistor R2 and a chassis ground. The third switch SW3 is a switching element capable of controlling the electrical operation, and the operation thereof is controlled by a battery control apparatus 12.

The reference voltage AG is connected between the second resistor R2 and the third switch SW3. Note that the reference voltage AG has a value different from that of the chassis ground.

The electric leakage detection apparatus according to this embodiment is the same as that according to the aforementioned first embodiment except for the insulation resistance drop detector 16 and the battery control apparatus 12 described above.

Hereinafter, the electric leakage detection method using the insulation resistance drop detector 16 will be described with reference to FIG. 4.

In this embodiment, the battery control apparatus 12 can open the third switch SW3, close a first switch SW1 and a second switch SW2 and measure a total voltage Vb.

That is, in a state where the first switch SW1 and the second switch SW2 are closed and the third switch SW3 is opened, the battery control apparatus 12 detects, by a voltage detector VS, a voltage PS_P between the first positive electrode side resistor R1P and the third positive electrode side resistor R3P and a voltage PS_N between the first negative electrode side resistor R1N and the third negative electrode side resistor R3N.

Subsequently, the battery control apparatus 12 computes the total voltage Vb by the following expression (4) using the values of the detected voltages PS_P and PS_N, the values (= R1) of the first positive electrode side resistor R1P and the first negative electrode side resistor R1N and the values (= R3) of the third positive electrode side resistor R3P and the third negative electrode side resistor R3N.

$$\text{Vb} = (|PS\_P| + |PS\_N|) \times \{(2R1 + 2R3)/2R3\} \quad \ldots \quad (4)$$

Subsequently, the battery control apparatus 12 compares the total voltage Vb obtained by the expression (4) with a voltage VPN between a total positive electrode terminal P and a total negative electrode terminal N, which is obtained by integrating battery cell voltages of battery modules MDL1 to MDL14 received from battery monitoring circuits 11.

When the difference between the voltage VPN and the total voltage Vb is equal to or greater than a predetermined threshold value, the battery control apparatus 12 determines that a battery pack 10 has trouble. That is, when the battery monitoring circuits 11, the battery control apparatus 12 and the insulation resistance drop detector 16 are operating normally, substantially equal values of the voltage VPN and the total voltage Vb are obtained. However, when the difference between the voltage VPN and the total voltage Vb is equal to or greater than the predetermined threshold value, for example, there is a possibility that the wiring of the insulation resistance drop detector 16 is disconnected, the switches have trouble, or the like, and there is a possibility that the battery pack 10 cannot be compensated to normally operate and the battery pack 10 has trouble.

In this case, the battery control apparatus 12, for example, notifies a vehicle ECU 30 of the trouble. In response to the receipt of the notification of the trouble from the battery control apparatus 12, the vehicle ECU 30, for example, transmits a command to stop the operation (charging, discharging or the like) to the battery control apparatus 12 and stops the battery pack 10.

Moreover, according to the insulation resistance drop detector 16 of the electric leakage detection apparatus of this embodiment, total voltages Vb1 and Vb2 can be measured. Therefore, in the electric leakage detection apparatus according to this embodiment, even in a case where the total voltage Vb1 when the voltage VL1 is measured and the total voltage Vb2 when the voltage VL2 is measured are different, a value of a total insulation resistance can be accurately computed. When the total voltage Vb1 and the total voltage Vb2 have a relationship of Vb1 = k × Vb2, the total insulation resistance RL can be computed by the following expression (5).

[Expression 4]

$$RL = \frac{R2}{\dfrac{VL1}{Vb1} - \dfrac{VL2}{Vb2}} - (R1 + R3 + R2) \quad \cdots (5)$$

According to the electric leakage detection apparatus of this embodiment, the battery control apparatus 12 detects the voltage VL1 by the voltage detector VS in a state where the first switch SW1 is closed, the second switch SW2 is opened, and the third switch SW3 is closed. Subsequently, in a state where the first switch SW1 is closed, the second switch SW2 is closed, and the third switch SW3 is opened, the battery control apparatus 12 detects the voltages PS_P and PS_N by the voltage detector VS and computes the total voltage Vb1 by the above expression (5) using the detected voltages PS_P and PS_N.

The battery control apparatus 12 detects the voltage VL2 by the voltage detector VS in a state where the first switch SW1 is opened, the second switch SW2 is closed, and the third switch SW3 is closed. Subsequently, in a state where the first switch SW1 is closed, the second switch SW2 is closed, and the third switch SW3 is opened, the battery control apparatus 12 detects the voltages PS_P and PS_N by the voltage detector VS and computes the total voltage Vb2 by the above expression (5) using the detected voltages PS_P and PS_N.

The battery control apparatus 12 computes the total insulation resistance RL from the above expression (5) using the voltages VL1 and VL2 obtained by the voltage detector VS and the total voltages Vb1 and Vb2 computed by the expression (5) at the same time.

If there is a time difference, during charging or discharging of the battery pack 10, between the timing of measuring the voltage VL1 and the timing of measuring the total voltage Vb1 and between the timing of measuring the voltage VL2 and the timing of measuring the total voltage Vb2, there is a possibility of an error (misdetection). On the other hand, according to above the electric leakage detection apparatus and electric leakage detection method, it is possible to compute the total voltages Vb1 and Vb2 based on the measured voltages PS_P and PS_N immediately after the voltages VL1 and VL2 at both ends of the second resistor R2 are measured, and it is possible to compute the total insulation resistance RL more accurately.

The battery control apparatus 12 compares the value of the insulation resistance RL calculated as described above with a predetermined electric leakage threshold value (e.g., 100 kΩ or less) and determines the presence of electric leakage when the insulation resistance RL is equal to or less than the predetermined electric leakage threshold value. When the presence of the electric leakage is determined, the battery control apparatus 12, for example, notifies the vehicle ECU 30 of the trouble (error). In response to the receipt of the notification of the trouble from the battery control apparatus 12, the vehicle ECU 30, for example, transmits a command to stop the operation (charging, discharging or the like) to the battery control apparatus 12 and stops the battery pack 10.

That is, according to this embodiment, it is possible to obtain the same effects as the aforementioned first embodiment. Furthermore, according to this embodiment, by comparing the voltage VPN between the total positive electrode terminal P and the total negative electrode terminal N obtained from the cell voltages with the total voltage Vb obtained by the expression (2), the trouble of the battery pack 10 can be determined, and it is possible to compensate the electric leakage detection apparatus to operate normally and detect electric leakage more accurately.

Meanwhile, when a state where the first switch SW1 is closed and the second switch SW2 is opened transitions into a state where the first switch SW1 is opened and the second switch SW2 is closed, there is a possibility that it takes time to the total voltage Vb1 ≈ the total voltage Vb2. In the insulation resistance measuring apparatus according to this embodiment, for example, the battery control apparatus 12 can obtain an accurate total insulation resistance RL even in a case where the voltages VL2 and Vb2 are measured at the timings when the total voltage Vb2 is stable.

FIG. 8 is a diagram showing one example of the total voltage of the battery pack controlled in a predetermined range in time series.

For example, in a hybrid electric vehicle (HEV) or in an electric vehicle in which an idling stop system (ISS) is mounted, the voltage of the battery pack is controlled in a predetermined range as shown in FIG. 8. In this case, the voltage (total voltage Vb) of the battery pack periodically becomes an intermediate value between the maximum value and the minimum value. Therefore, if the specifications are made to acquire the data of the voltages VL1 and VL2 when the voltage of the battery pack becomes an intermediate value between the maximum value and the minimum value, the voltage measurement time can be shortened.

Moreover, in the insulation resistance drop detector 16 of the electric leakage detection apparatus according to the above second embodiment, when the third switch SW3 is brought into a closed state, it is possible to detect electric leakage by the same operation as in the aforementioned first embodiment. Note that, in the insulation resistance drop detector 16 according to this embodiment, the computation can be made by the following expression by replacing R1 with R1 + R3 in the expression (3) of the first embodiment.

[Expression 5]

$$ RL = \frac{R2 \times Vb}{VL1 - VL2} - (R1 + R3 + R2) \quad \cdot \cdot \cdot \quad (6) $$

According to the first embodiment and the second embodiment as described above, it is possible to provide an electric leakage detection apparatus and an electric leakage detection method, which accurately detect electric leakage.

Although several embodiments of the present invention have been described, these embodiments have been presented by way of example and are not intended to limit the scope of the invention. These novel embodiments can be implemented in various other forms, and various omissions, substitutions and changes can be made in a scope without departing from the gist of the invention. These embodiments and modifications thereof are included in the scope and gist of the invention and are included in the invention described in the claims and the equivalent scope thereof.

For example, in the first embodiment and the second embodiment described above, the battery control apparatus 12 may record not only the voltages VL1 and Vb1 but also the voltages VL2 and Vb2 in the memory in advance. For example, the battery control apparatus 12 can shorten the electric leakage detection time by using newer data of the voltages VL1 and Vb1 and the voltages VL2 and Vb2 recorded in the memory. For example, the battery control apparatus 12 uses the voltages VL1 and Vb1 recorded in the memory, measures the values of the plurality of voltages VL2 and Vb2 to update the memory, calculates the insulation resistance RL by using the voltages VL1 and VL2 in which the total voltage Vb1 and the total voltage Vb2 are equal, uses the voltages VL2 and Vb2 recorded in the memory next time, measures the values of the plurality of voltages VL1 and Vb1 to update the memory, and calculates the insulation resistance RL by using the voltages VL1 and VL2 in which the total voltage Vb1 and the total voltage Vb2 are equal. By repeating this operation with the battery control apparatus 12, accurate electric leakage detection can be realized while the data in the memory is updated.

**Claims**

1.  An electric leakage detection method of an electric leakage detection apparatus comprising:

    a first terminal electrically connected to a main circuit positive electrode terminal of a storage battery group;
    a second terminal electrically connected to a main circuit negative electrode terminal of the storage battery group;
    a first switch that switches electrical connection between the first terminal and a ground;
    a second switch that switches electrical connection between the second terminal and the ground;
    a first positive electrode side resistor and a second resistor connected in series between the first switch and the ground;
    a first negative electrode side resistor connected in series to the second resistor between the second switch and the ground;
    a voltage detector that detects a voltage at both ends of the second resistor; and
    a control apparatus that comprises a memory and records, in the memory, a value of the voltage detected by the voltage detector and a total voltage between the first terminal and the second terminal, the total voltage being computed based on a voltage transmitted from a monitoring apparatus that monitors a cell voltage of the storage battery group,
    the electric leakage detection method comprising:

    measuring a set of a first voltage, which is the voltage at both ends of the second resistor, and the total voltage a plurality of times to be recorded in the memory by the control apparatus in a state where one of the first switch and the second switch is closed and an other of the first switch and the second switch is opened;
    measuring, by the voltage detector, at least one second voltage, which is the voltage at both ends of the second resistor and corresponds to the total voltage whose difference from any one of a plurality of the total voltages recorded in the memory is equal to or less than a voltage threshold value, in a state where one of the first switch and the second switch is opened and an other of the first switch and the second switch is closed;
    computing a total insulation resistance between the storage battery group and the ground by using the total voltage, the first voltage, and the second voltage; and
    determining presence of electric leakage when a value of the total insulation resistance is equal to or less than an electric leakage threshold value.

2.  The electric leakage detection method according to claim 1, wherein when the control apparatus measures a set of the second voltage, which is the voltage at both ends of the second resistor, and the total voltage a plurality of times to be recorded in the memory in a state where one of the first switch and the second switch is opened and an other of the first switch and the second switch is closed.

3.  The electric leakage detection method of the electric leakage detection apparatus according to claim 1 or 2 further comprising:

    a third switch that switches electrical connection between the second resistor and the ground;
    a reference voltage connected between the third switch and the second resistor;
    a third positive electrode side resistor connected in series between the first positive electrode side resistor and the second resistor; and
    a third negative electrode side resistor connected in series between the first negative electrode side resistor and the second resistor,
    the electric leakage detection method further comprising:

    detecting, by the control apparatus, a voltage between the first positive electrode side resistor and the third positive electrode side resistor and a voltage between the first negative electrode side resistor and the third negative electrode side resistor with the voltage detector in a state where the first switch is closed, the second switch is closed and the third switch is opened;
    computing a voltage between the first terminal and the second terminal by using a value detected by the voltage detector to be compared with the total voltage; and
    determining presence of trouble when a difference between the total voltage and the voltage between the first terminal and the second terminal is equal to or greater than a predetermined threshold value.

**4.** An electric leakage detection method of an electric leakage detection apparatus comprising:

a first terminal electrically connected to a main circuit positive electrode terminal of a storage battery group;
a second terminal electrically connected to a main circuit negative electrode terminal of the storage battery group;
a first switch that switches electrical connection between the first terminal and a ground;
a second switch that switches electrical connection between the second terminal and the ground;
a first positive electrode side resistor and a second resistor connected in series between the first switch and the ground;
a first negative electrode side resistor connected in series to the second resistor between the second switch and the ground;
a third switch that switches electrical connection between the second resistor and the ground;
a reference voltage connected between the third switch and the second resistor;
a third positive electrode side resistor connected in series between the first positive electrode side resistor and the second resistor;
a third negative electrode side resistor connected in series between the first negative electrode side resistor and the second resistor;
a voltage detector that detects a voltage at both ends of the second resistor, a voltage between the first positive electrode side resistor and the third positive electrode side resistor and a voltage between the first negative electrode side resistor and the third negative electrode side resistor; and
a control apparatus that controls operations of the first switch, the second switch, and the third switch,
the electric leakage detection method comprising:

measuring, by the control apparatus, a first voltage, which is the voltage at both ends of the second resistor, with the voltage detector in a state where one of the first switch and the second switch is closed, an other of the first switch and the second switch is opened and the third switch is closed;
detecting, by the voltage detector, the voltage between the first positive electrode side resistor and the third positive electrode side resistor and the voltage between the first negative electrode side resistor and the third negative electrode side resistor in a state where the first switch is closed, the second switch is closed and the third switch is opened, and computing a first total voltage between the first terminal and the second terminal by using values detected by the voltage detector;
measuring, by the voltage detector, a second voltage, which is the voltage at both ends of the second resistor, in a state where one of the first switch and the second switch is opened, an other of the first switch and the second switch is closed and the third switch is closed;
detecting, by the voltage detector, the voltage between the first positive electrode side resistor and the third positive electrode side resistor and the voltage between the first negative electrode side resistor and the third negative electrode side resistor in a state where the first switch is closed, the second switch is closed and the third switch is opened, and computing a second total voltage between the first terminal and the second terminal by using values detected by the voltage detector;
computing a total insulation resistance between the storage battery group and the ground by using the first total voltage, the second total voltage, the first voltage and the second voltage; and
determining presence of electric leakage when a value of the total insulation resistance is equal to or less than an electric leakage threshold value.

**5.** An electric leakage detection apparatus comprising:

a first terminal electrically connected to a main circuit positive electrode terminal of a storage battery group;
a second terminal electrically connected to a main circuit negative electrode terminal of the storage battery group;
a first switch that switches electrical connection between the first terminal and a ground;
a second switch that switches electrical connection between the second terminal and the ground;
a first positive electrode side resistor and a second resistor connected in series between the first switch and the ground;
a first negative electrode side resistor connected in series to the second resistor between the second switch and the ground;
a third switch that switches electrical connection between the second resistor and the ground;
a reference voltage connected between the third switch and the second resistor;
a third positive electrode side resistor connected in series between the first positive electrode side resistor and the second resistor;
a third negative electrode side resistor connected in series between the first negative electrode side resistor and the second resistor;

a voltage detector that detects a voltage at both ends of the second resistor, a voltage between the first positive electrode side resistor and the third positive electrode side resistor and a voltage between the first negative electrode side resistor and the third negative electrode side resistor; and

a control apparatus that controls operations of the first switch, the second switch and the third switch.

F I G. 1

EP 3 489 698 A1

F I G. 2

F I G. 3

14

FIG. 4

15

## F I G. 5

## F I G. 6

Detection time

R2 voltage : VL2

SW1 ON
SW2 OFF

SW1 OFF
SW2 ON

FIG. 7

Total voltage

Maximum value

Intermediate value

Time

Minimum value

FIG. 8

## INTERNATIONAL SEARCH REPORT

| International application No. |
| --- |
| PCT/JP2017/024227 |

**A. CLASSIFICATION OF SUBJECT MATTER**
*G01R31/02*(2006.01)i, *G01R31/36*(2006.01)i, *H01M10/48*(2006.01)i, *H02H3/00* (2006.01)i, *H02J7/00*(2006.01)i

According to International Patent Classification (IPC) or to both national classification and IPC

**B. FIELDS SEARCHED**

Minimum documentation searched (classification system followed by classification symbols)
G01R31/02, G01R31/36, H01M10/48, H02H3/00, H02J7/00

Documentation searched other than minimum documentation to the extent that such documents are included in the fields searched
Jitsuyo Shinan Koho          1922-1996     Jitsuyo Shinan Toroku Koho     1996-2017
Kokai Jitsuyo Shinan Koho     1971-2017     Toroku Jitsuyo Shinan Koho     1994-2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2003-66090 A (Omron Corp.), 05 March 2003 (05.03.2003), entire text; all drawings & US 2003/0042909 A1 & EP 1289094 A1 | 1-5 |
| A | JP 2015-518141 A (LG Chem, Ltd.), 25 June 2015 (25.06.2015), entire text; all drawings & US 2014/0095093 A1 & EP 2801837 A1 & WO 2013/147494 A1 | 1-5 |
| A | JP 8-163704 A (Fujikura Ltd.), 21 June 1996 (21.06.1996), entire text; all drawings (Family: none) | 1-5 |

[X] Further documents are listed in the continuation of Box C.     [ ] See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 04 September 2017 (04.09.17) | 19 September 2017 (19.09.17) |

| Name and mailing address of the ISA/ Japan Patent Office 3-4-3,Kasumigaseki,Chiyoda-ku, Tokyo 100-8915,Japan | Authorized officer |
| | Telephone No. |

Form PCT/ISA/210 (second sheet) (January 2015)

**INTERNATIONAL SEARCH REPORT**

| International application No. |
|---|
| PCT/JP2017/024227 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 8-320352 A (Matsushita Electric Industrial Co., Ltd.), 03 December 1996 (03.12.1996), entire text; all drawings (Family: none) | 1-5 |
| A | JP 2004-219414 A (Daimler Chrysler AG), 05 August 2004 (05.08.2004), entire text; all drawings & US 2004/0189330 A1    & EP 1437600 A1 & DE 10300539 A1 | 1-5 |
| A | US 2013/0314097 A1 (MAGNA E-CAR SYSTEMS GMBH & CO.OG), 28 November 2013 (28.11.2013), entire text; all drawings & EP 2570289 A1 | 1-5 |

Form PCT/ISA/210 (continuation of second sheet) (January 2015)

**EP 3 489 698 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2838462 B